(19) Europäisches Patentamt
European Patent Office
Office européen des brevets

(11) **EP 3 955 275 A1**

(12) **EUROPEAN PATENT APPLICATION**
published in accordance with Art. 153(4) EPC

(43) Date of publication:
**16.02.2022 Bulletin 2022/07**

(21) Application number: **20818452.3**

(22) Date of filing: **12.05.2020**

(51) International Patent Classification (IPC):
**H01H 36/00** *(2006.01)* **B32B 7/023** *(2019.01)*
**G06F 3/02** *(2006.01)*

(52) Cooperative Patent Classification (CPC):
**B32B 7/023; G06F 3/02; H01H 36/00**

(86) International application number:
**PCT/JP2020/018983**

(87) International publication number:
**WO 2020/246203 (10.12.2020 Gazette 2020/50)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **07.06.2019 JP 2019107308**

(71) Applicant: **Sekisui Polymatech Co., Ltd.
Saitama-city, Saitama 338-0837 (JP)**

(72) Inventor: **YAMAMOTO, Yohei
Saitama-city, Saitama 338-0837 (JP)**

(74) Representative: **Schmid, Wolfgang
Lorenz & Kollegen
Patentanwälte Partnerschaftsgesellschaft mbB
Alte Ulmer Strasse 2
89522 Heidenheim (DE)**

(54) **SENSOR-SHEET-CONTAINING EXTERIOR ARTICLE**

(57) A sensor-sheet-containing exterior component is provided. The sensor-sheet-containing exterior component has a devised decorating layer that decorates a display portion appearing on the surface of an exterior member, which enables a wide variety of display patterns and thereby imparts design flexibility to the sensor-sheet-containing exterior component. A sensor-sheet-containing exterior component 1 in which an exterior member 30 and a sensor sheet 10 are layered includes a decorating layer K1, K2 that decorates display portions D1 - D6 that appear on a surface of the exterior member 30. The decorating layer K1, K2 includes a first decorating layer K1 disposed in the exterior member 30 and a second decorating layer K2 positioned closer than the first decorating layer K1 to the sensor sheet 10 and disposed in a member separate from the exterior member 30.

Fig.1

**Description**

Technical Field

The present invention relates to a sensor-sheet-containing exterior component that includes a sensor sheet to be used for various types of electronic devices and is integrally formed with an exterior member.

Background Art

International Publication No. WO2011/142332 (PTL 1) describes a sensor-sheet-containing exterior component in which a sensor sheet and an exterior member are integrally formed. As described in PTL 1, the sensor-sheet-containing exterior component is typically configured such that the sensor sheet is fixed to the backside of a panel, or the exterior member, using an adhesive layer or a double-sided adhesive tape.

Citation List

Patent Literature

PTL 1: International Publication No. WO2011/142332

Summary of Invention

Technical Problem

Such a sensor-sheet-containing exterior component is used, for example, in an instrument panel of an automobile, and design flexibility is demanded. The sensor sheet, however, is not readily deformable because the sensor sheet is typically formed of a resin film, and the sensor sheet needs to be fixed easily to, and integrated easily with, the exterior member. As a result, the design of the sensor-sheet-containing exterior component has tended to be simplified.

Solution to Problem

According to an aspect of the present invention, a sensor-sheet-containing exterior component in which an exterior member and a sensor sheet are layered includes a decorating layer that decorates a display portion that appears on a surface of the exterior member. The decorating layer includes a first decorating layer disposed in the exterior member and a second decorating layer positioned closer than the first decorating layer to the sensor sheet and disposed in a member separate from the exterior member.

Advantageous Effects of Invention

The sensor-sheet-containing exterior component according to the present invention enables a wide variety of display patterns on the surface of the exterior member, which improves design flexibility.

Brief Description of Drawings

[Fig. 1] Fig. 1 is a plan view illustrating a sensor-sheet-containing exterior component according to a first embodiment of the present invention.
[Fig. 2] Fig. 2 is a perspective view illustrating a layer structure of the sensor-sheet-containing exterior component of Fig. 1.
[Figs. 3] Figs. 3 are views illustrating a sensor sheet used in the sensor-sheet-containing exterior component of Fig. 1, in which Fig. 3A is a plan view, Fig. 3B is a cross section taken along line 3B-3B in Fig. 3A, and Fig. 3C is a cross section taken along line 3C-3C in Fig. 3A.
[Figs. 4] Figs. 4 are views illustrating an intermediate sheet used in the sensor-sheet-containing exterior component of Fig. 1, in which Fig. 4A is a plan view, Fig. 4B is a cross section taken along line 4B-4B in Fig. 4A, Fig. 4C is a cross section taken along line 4C-4C in Fig. 4A, and Fig. 4D a cross section taken along line 4D-4D in Fig. 4A.
[Figs. 5] Figs. 5 are views illustrating an exterior member used in the sensor-sheet-containing exterior component of Fig. 1, in which Fig. 5A is a plan view, Fig. 5B is a cross section taken along line 5B-5B in Fig. 5A, Fig. 5C is a cross section taken along line 5C-5C in Fig. 5A, and Fig. 5D a cross section taken along line 5D-5D in Fig. 5A.

[Fig. 6] Fig. 6 is a perspective view illustrating a layer structure of a sensor-sheet-containing exterior component according to a second embodiment of the present invention.

[Fig. 7] Fig. 7 is a plan view of a sensor sheet used in the sensor-sheet-containing exterior component of Fig. 6.

[Figs. 8] Figs. 8 are cross-sectional views of the sensor sheet of Fig. 7, in which Fig. 8A is a cross section taken along line 8A-8A in Fig. 7, Fig. 8B is a cross section taken along line 8B-8B in Fig. 7, Fig. 8C is a cross section taken along line 8C-8C in Fig. 7, and Fig. 8D is a cross section taken along line 8D-8D in Fig. 7.

[Fig. 9] Fig. 9 is a perspective view illustrating a layer structure of a sensor-sheet-containing exterior component according to a third embodiment of the present invention.

[Figs. 10] Figs. 10 are views illustrating a sensor sheet used in the sensor-sheet-containing exterior component of Fig. 9, in which Fig. 10A is a plan view, Fig. 10B is a cross section taken along line 10B-10B in Fig. 10A, and Fig. 10C is a cross section taken along line 10C-10C in Fig. 10A.

[Figs. 11] Figs. 11 are views illustrating an intermediate sheet used in the sensor-sheet-containing exterior component of Fig. 9, in which Fig. 11A is a plan view, Fig. 11B is a cross section taken along line 11B-11B in Fig. 11A, Fig. 11C is a cross section taken along line 11C-11C in Fig. 11A, and Fig. 11D is a cross section taken along line 11D-11D in Fig. 11A.

[Figs. 12] Figs. 12 are views illustrating sensor-sheet-containing exterior components equipped with respective inner members, in which Fig. 12A is a cross section of the sensor-sheet-containing exterior component of the first and third embodiment, and Fig. 12B is a cross section of the sensor-sheet-containing exterior component of the second embodiment.

[Figs. 13] Figs. 13 are views illustrating a test piece of the sensor-sheet-containing exterior component prepared for Examples, in which Fig. 13A is a plan view, and Fig. 13B is a cross section taken along line 13B-13B in Fig. 13A.

[Figs. 14] Figs. 14 are views illustrating another test piece of the sensor-sheet-containing exterior component prepared for Examples, in which Fig. 14A is a plan view, and Fig. 14B is a cross section taken along line 14B-14B in Fig. 14A.

Description of Embodiments

A sensor-sheet-containing exterior component 1 according to an embodiment of the present invention will be described in detail with reference to the drawings. The sensor-sheet-containing exterior component 1 is to be disposed at the front face of an electronic appliance. Note that components used commonly in different embodiments are denoted by the same reference signs, and duplicated descriptions will be omitted. Duplicated descriptions of materials, operation, advantageous effects, and others that are common in different embodiments will be also omitted.

Components are illustrated schematically in the drawings. The size, the dimensional relationship, the surface geometry of each component may vary for convenience of description.

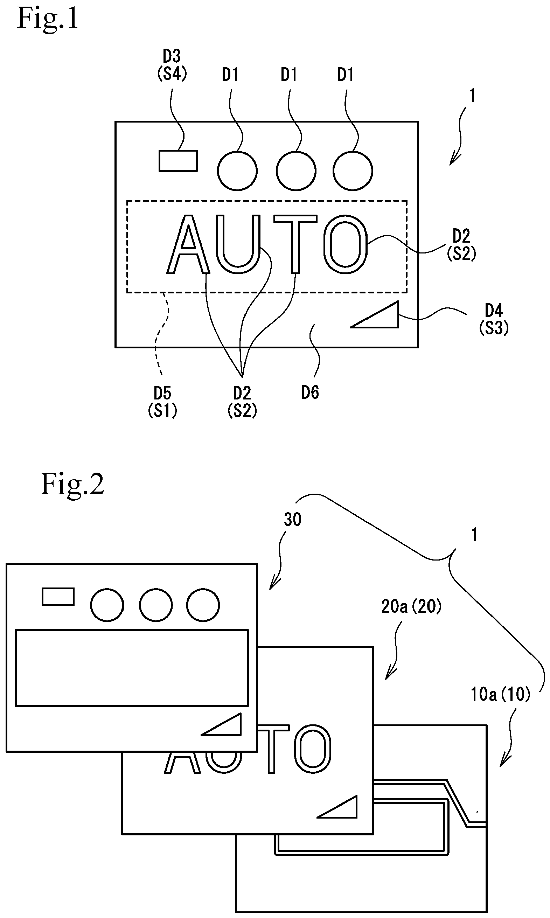

First Embodiment (Figs. 1 to 5)

Fig. 1 is a plan view illustrating the sensor-sheet-containing exterior component 1 according to a first embodiment. The sensor-sheet-containing exterior component 1 can be used as an exterior component (housing) of an electronic device, such as an electric appliance, an audio appliance, or an instrument mounted in an automobile. As illustrated in Fig. 2, the sensor-sheet-containing exterior component 1 includes an exterior member 30 and a sensor sheet 10 disposed at the backside of the exterior member 30. The sensor-sheet-containing exterior component 1 also includes an intermediate sheet 20 disposed between the exterior member 30 and the sensor sheet 10. In the present specification and also in the claims, the side of the sensor-sheet-containing exterior component 1 at which the exterior member 30 is disposed is referred to as the "front side" for convenience of description, while the side at which the sensor sheet 10 is disposed is referred to as the "backside". Next, portions constituting the sensor-sheet-containing exterior component 1 are described below.

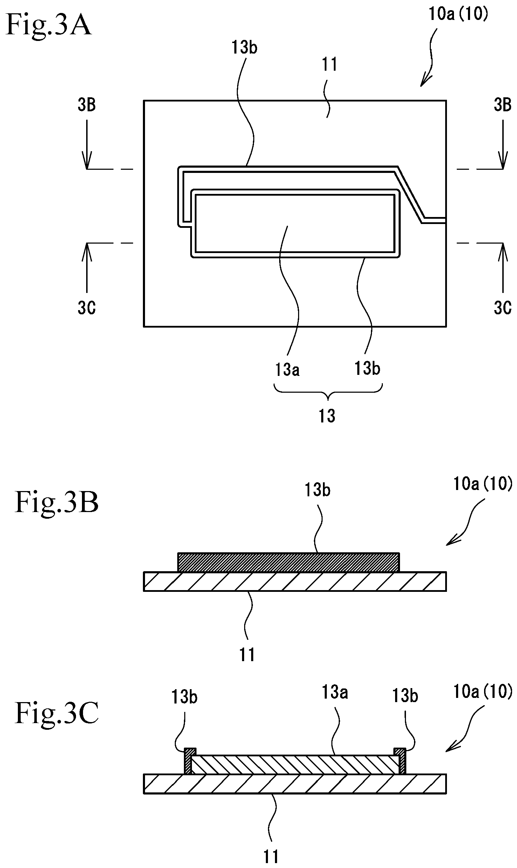

Fig. 3A is a plan view illustrating the sensor sheet 10 (a sensor sheet 10a according to the first embodiment). The sensor sheet 10 includes a sensor substrate 11 formed of a highly transparent resin film and a sensor 13 disposed on the surface of a sensor substrate 11. Multiple sensors 13 may be disposed on the sensor substrate 11. The sensor 13 has a highly transparent sensor electrode 13a and a conducting wire 13b extending from the sensor electrode 13a. An end of the conducting wire 13b is coupled to a terminal (not illustrated). The sensor 13 can serve as a touch sensor. When a user touches a surface portion (operation portion) of an exterior light diffusion layer 35 that is positioned at the sensor electrode 13a, the touch of the user changes the capacitance of the sensor 13. A processor detects the change of the capacitance. The sensor 13 thereby functions as the touch sensor that outputs an operation signal in response to the user's touch. The sensor sheet 10 may have a protrusion that protrudes outward from the outer frame of the exterior member 30. Part of the conducting wire 13b and a terminal may be disposed on the protrusion. The protrusion may be bent in advance so that the terminal can be appropriately connected to a circuit board or the like. The sensor sheet 10 may have a highly transparent resist layer (not illustrated) formed on the surface thereof. The resist layer can protect the conducting wire 13b and others.

Fig. 3B and Fig. 3C are cross-sectional views of the sensor sheet 10. As illustrated in Fig. 3B, the conducting wire 13b can be printed on the surface of the sensor substrate 11 using a conductive paste or the like. As illustrated in Fig. 3C, the sensor electrode 13a also can be printed on the surface of the sensor substrate 11 using a conductive ink made of a transparent conductive polymer or the like.

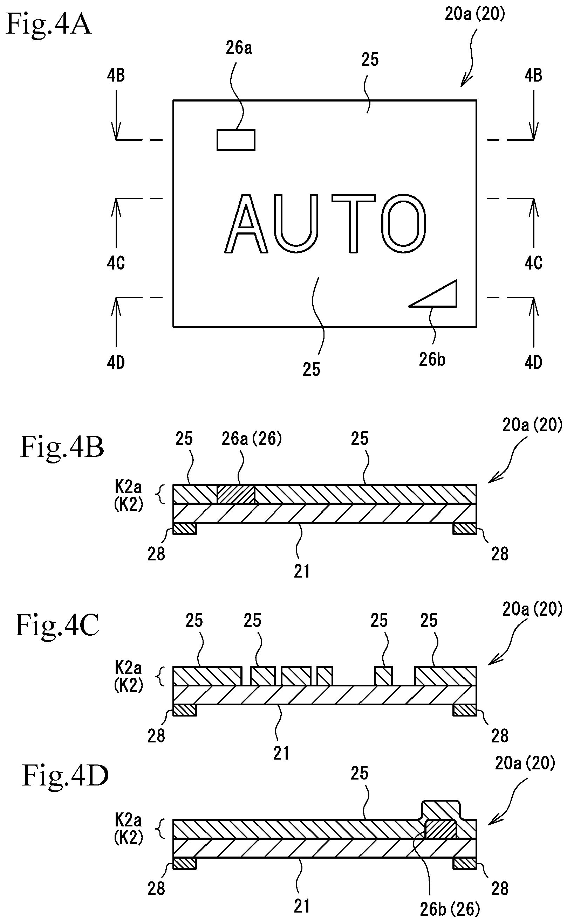

Fig. 4A is a plan view of an intermediate sheet 20 (an intermediate sheet 20a according to the first embodiment). As illustrated in the cross-sectional views of Figs. 4B to 4D, the intermediate sheet 20 has an intermediate substrate 21 formed of a transparent resin film. An intermediate decorating layer K2a, which serves as a second decorating layer K2, is formed on a surface of the intermediate substrate 21. The intermediate decorating layer K2a includes an intermediate light diffusion layer (second light diffusion layer) 25 that can transmit and scatter light and also includes an intermediate coloring layer 26 for displaying letters and symbols. In the present embodiment, the intermediate coloring layer 26 is formed of a red coloring layer 26a and a blue coloring layer 26b. The light-transmissive and also light-diffusive intermediate light diffusion layer 25 can be obtained, for example, by disposing a semitransparent and colored coloring layer similar, for example, to colored smoky glass.

More specifically, in the layer configuration of the intermediate sheet 20, as illustrated in the plan view of Fig. 4A, a triangular shape (shape displaying portion) is formed of a transparent blue coloring layer (second transparent coloring layer) 26b. A rectangular shape (shape displaying portion) in Fig. 4A is formed of a transparent red coloring layer (first transparent coloring layer) 26a. The intermediate light diffusion layer 25 is formed on the surface of the intermediate substrate 21 in a region excluding the letters "AUTO" (letter displaying portion) and the rectangularly-shaped red coloring layer 26a. In other words, as illustrated in Fig. 4B, the rectangular shape can be printed on the surface of the intermediate substrate 21 using a transparent red ink. As illustrated in Fig. 4C, the letters "AUTO" can be formed by printing the intermediate light diffusion layer 25 on the surface of the intermediate substrate 21 in such a manner that the letters "AUTO" are cut out through the intermediate light diffusion layer 25. As illustrated in Fig. 4D, the triangular shape can be formed by printing the triangular shape on the surface of the intermediate substrate 21 using a transparent blue ink and subsequently printing the intermediate light diffusion layer 25 thereon. Accordingly, the intermediate light diffusion layer 25 is not layered over the rectangular shape, whereas the intermediate light diffusion layer 25 is layered over the triangular shape. Thus, the intermediate decorating layer K2a is formed by layering the intermediate coloring layer 26a, 26b and the intermediate light diffusion layer 25.

An example of an ink used to print the light diffusion layer (intermediate light diffusion layer 25) is an ink containing light-diffusive filler or an ink that can generate light scattering irregularities on the ink surface after the ink dries or solidifies. Alternatively, the light diffusion layer can be formed, for example, of a resin layer containing the light-diffusive filler or having light-diffusive irregularities on the surface thereof.

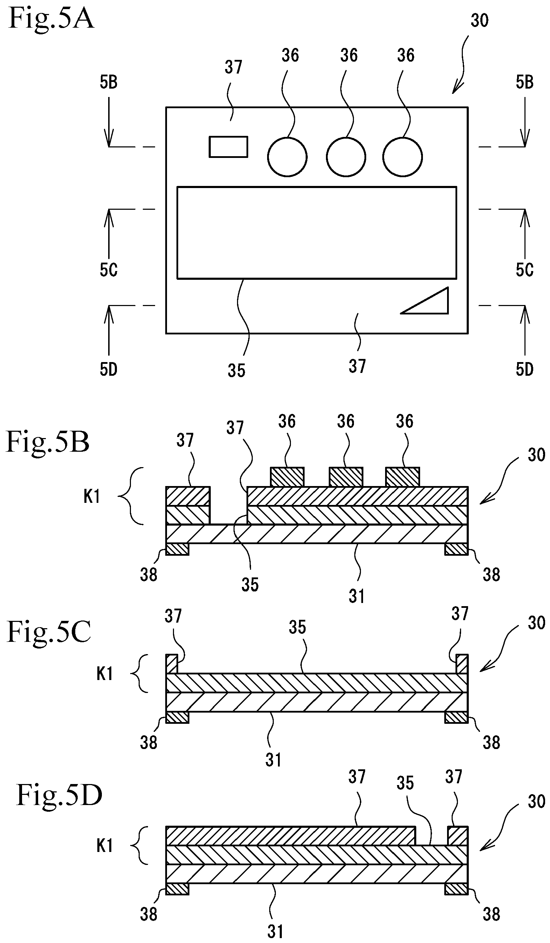

Fig. 5A is a plan view illustrating the exterior member 30. The exterior member 30 has an exterior substrate 31 formed of a transparent hard resin. An exterior decorating layer K1, which serves as a first decorating layer K1, is formed on a surface of the exterior substrate 31. The exterior decorating layer K1 includes an exterior light blocking layer 37 that forms a light blocking portion, an exterior light diffusion layer (first light diffusion layer) 35 that can transmit and scatter light, and an exterior coloring layer 36 that displays at least either letters or symbols. Similarly to the intermediate light diffusion layer 25, the exterior light diffusion layer 35 can be formed as a semitransparent and colored coloring layer similar, for example, to colored smoky glass. The color of the exterior light blocking layer 37 is the same as, or similar to (or related to), the color of the exterior light diffusion layer 35 or of the intermediate light diffusion layer 25, in other words, such a color that is not easily distinguishable when viewed. The color of the exterior light diffusion layer 35 is the same as or similar to the color of the intermediate light diffusion layer 25. In the present embodiment, the colors of the exterior light blocking layer 37 and the exterior light diffusion layer 35 are both dark.

More specifically, in the layer configuration of the exterior member 30, as illustrated in the plan view of Fig. 5A, three circular shapes are formed of a white exterior coloring layer 36 that blocks light. The exterior light blocking layer 37 covers a region excluding the triangular shape at the lower right corner, the rectangular shape at the upper left corner, and a large rectangular shape at the center. The intermediate light diffusion layer 25 covers a region excluding the rectangular shape at the upper left corner. Figs. 5B to 5D are cross-sectional views of the exterior member 30. As illustrated in Fig. 5B, the rectangular shape at the upper left corner is formed by masking the rectangular shape while printing the exterior light diffusion layer 35 and the exterior light blocking layer 37. As illustrated in Fig. 5C, the large rectangular shape at the center is formed by printing the exterior light diffusion layer 35 on the surface of the exterior substrate 31 and subsequently printing the exterior light blocking layer 37 thereon using a light blocking ink while the large rectangular shape is masked. As illustrated in Fig. 5D, the triangular shape is formed by printing the exterior light diffusion layer 35 on the surface of the exterior substrate 31 and subsequently printing the exterior light blocking layer 37 thereon using the light blocking ink while the triangular shape is masked. Accordingly, the exterior light diffusion layer 35 is not formed in the rectangular shape, while the exterior light diffusion layer 35 is formed in the triangular shape.

Thus, the exterior decorating layer K1 is formed by layering the exterior coloring layer 36, the exterior light diffusion layer 35, and the exterior light blocking layer 37.

The sensor-sheet-containing exterior component 1 have various layered portions when the surface is viewed. As illustrated in Fig. 1, the layered portions include a first display portion D1 indicated by the three circles, a second display portion D2 indicated by the letters "AUTO", a third display portion D3 indicated by the rectangular shape, a fourth display portion D4 indicated by the triangular shape, a fifth display portion D5 indicated as the background of the letters "AUTO", and a peripheral portion D6 that is the remaining portion excluding display portions D1, D2, D3, D4, and D5.

Each of these portions D1, D2, D3, D4, D5, and D6 is layered as follows. The first display portion D1 indicated by the three circles is a portion that has the exterior coloring layer 36 as the surface layer. The second display portion D2 indicated by the letters "AUTO" is a portion that has the exterior light diffusion layer 35 and that does not have the intermediate light diffusion layer 25 when transparent layers are ignored. The second display portion D2 is also referred to as a second layered portion S2. The third display portion D3 indicated by the rectangular shape is a portion that has the intermediate coloring layer 26a and that does not include the exterior light diffusion layer 35 nor the intermediate light diffusion layer 25 when transparent layers are ignored. The third display portion D3 is also referred to as a fourth layered portion S4. The fourth display portion D4 indicated by the triangular shape is a portion having the intermediate coloring layer 26b and the intermediate light diffusion layer 25 when transparent layers are ignored. The fourth display portion D4 is also referred to as a third layered portion S3. The fifth display portion D5 indicated as the background of the letters "AUTO" is a portion having the intermediate light diffusion layer 25 and the exterior light diffusion layer 35 when transparent portions are ignored. The fifth display portion D5 is also referred to as a first layered portion S1. The peripheral portion D6, which is a portion excluding the display portions D1, D2, D3, D4, and D5, is a portion having the exterior light blocking layer 37 as the surface layer (outermost layer).

The sensor-sheet-containing exterior component 1 have the portions described above when the surface thereof is viewed. During daytime under sunlight, the first display portion D1, which has the three circular shapes with the exterior coloring layer 36 as the outermost layer, and the third display portion D3, which has the rectangular shape with the intermediate coloring layer 26 being visible, can be visually distinguished from the other portions. On the other hand, the second display portion D2 indicated by the letters "AUTO", which is the portion having the exterior light diffusion layer 35, becomes dark as is the fifth display portion D5, which is the background of the letters "AUTO". Accordingly, the second display portion D2 cannot be visually distinguished from the fifth display portion D5. The fourth display portion D4 indicated by the triangular shape is not visible because the fourth display portion D4 has the intermediate light diffusion layer 25 and the intermediate coloring layer 26 when transparent layers are ignored and the intermediate light diffusion layer 25 comes to the outermost layer. The fifth display portion D5, which is the background of the letters "AUTO", is a portion having the intermediate light diffusion layer 25 and the exterior light diffusion layer 35. The fifth display portion D5 is as dark as the peripheral portion D6, and the fifth display portion D5 cannot be visually distinguished from the peripheral portion D6.

During nighttime with no sunlight, the first display portion D1 indicated by the three circles having the exterior coloring layer 36 as the outermost layer is still visible since weak light coming from outside illuminates the sensor-sheet-containing exterior component 1. On the other hand, the third display portion D3 indicated by the rectangular shape, which is visible during daytime, is not clearly distinguishable since the intermediate coloring layer 26a is disposed at the back of the exterior member 30. The other portions cannot be clearly distinguished, either.

When an internal light source (back light)(not illustrated) disposed at the back of the sensor-sheet-containing exterior component 1 is activated, the second display portion D2 indicated by the letters "AUTO" is illuminated with the light passing through the exterior light diffusion layer 35. The fifth display portion D5 that surrounds the letters "AUTO" is also illuminated with the light passing through two light diffusion layers, in other words, the intermediate light diffusion layer 25 and the exterior light diffusion layer 35. Accordingly, the fifth display portion D5 is illuminated more dimly than the letters "AUTO". The third display portion D3 indicated by the rectangular shape is illuminated with vividly colored light that passes through the intermediate coloring layer 26a. The fourth display portion D4 indicated by the triangular shape is illuminated with darkly colored light that passes through the intermediate coloring layer 26b but is weakened by the intermediate light diffusion layer 25. In contrast, the first display portion D1 indicated by the three circles and the peripheral portion D6 becomes invisible because the light from the internal light source is prevented from passing through. Thus, the second display portion D2, the third display portion D3, the fourth display portion D4, and the fifth display portion D5 are portions that are illuminated in different illumination states, whereas the first display portion D1 and the peripheral portion D6 are portions that are not illuminated.

In the sensor-sheet-containing exterior component 1, an adhesion layer 38 can be provided at the backside of the exterior substrate 31 at positions in a peripheral region that overlaps the exterior light blocking layer (light blocking portion) 37. The adhesion layer 38 adheres the exterior substrate 31 to the intermediate sheet 20a. An adhesion layer 28 can be provided at the backside of the intermediate substrate 21 at positions corresponding to the adhesion layer 38. The adhesion layer 28 adheres the intermediate substrate 21 to the sensor sheet 10a. The adhesion layer 38 and the adhesion layer 28 may be formed, for example, of an adhesive or a double-sided adhesive tape.

Advantageous Effects

1) The sensor-sheet-containing exterior component 1 includes the sensor sheet 10, 10a that can be used as an input device for electronic equipment, such as a home appliance, an audio appliance, or an instrument mounted in an automobile. The sensor-sheet-containing exterior component 1 can be used as a touch sensor that can detect a change in capacitance due to a user touching the sensor electrode 13a indirectly.

2) The sensor-sheet-containing exterior component 1 includes the exterior member 30 disposed at the front surface of the sensor sheet 10, 10a. Accordingly, the exterior member 30 can protect the sensor sheet 10, 10a and serve as a housing of an electronic device. The exterior member 30 can be decorated in various ways, which is suitable for the use for the housing of an electronic device.

3) The sensor-sheet-containing exterior component 1 includes the decorating layers (the first decorating layer K1 and the second decorating layer K2) that decorate the display portions that appear on the surface of the exterior member 30 (the first display portion D1, the second display portion D2, the third display portion D3, the fourth display portion D4, the fifth display portion D5, the peripheral portion D6). The sensor-sheet-containing exterior component 1 can be used as an input device that enables a user to input various types of information through the sensor sheet 10, 10a by touching the display portions (the second display portion D2 and the fifth display portion D5 in the present embodiment) that appear on the surface of the exterior member 30.

4) The decorating layer (K1, K2) includes the first decorating layer K1 that is disposed in the exterior member 30 and the second decorating layer K2 that is positioned closer than the first decorating layer K1 to the sensor sheet 30 and is disposed on a member (intermediate sheet 20a) separate from the exterior member 30. This enables a wide variety of display patterns and thereby imparts design flexibility to the sensor-sheet-containing exterior component 10, 10a.

5) The first decorating layer K1 and the second decorating layer K2 are positioned differently in the thickness direction of the sensor-sheet-containing exterior component 1. This can add an impression of depth to the decoration in the sensor-sheet-containing exterior component 1.

6) Multiple sensor-sheet-containing exterior components 1 having different designs can be obtained by providing different members (intermediate sheets 20a) having differently designed second decorating layers K2 while using the same exterior members 30 having the same first decorating layer K1. For example, this is useful for providing global models suitable for countries of different languages or for adapting the display design to functional changes of the sensor-sheet-containing exterior component 1.

7) The decorating layer K1, K2 has a light-transmissive and light-diffusive light diffusion layer (the exterior light diffusion layer 35, the intermediate light diffusion layer 25). The light diffusion layer includes a first light diffusion layer (the exterior light diffusion layer 35) disposed in the first decorating layer K1 and a second light diffusion layer (the intermediate light diffusion layer 25) disposed in the second decorating layer K2. As a result, the sensor-sheet-containing exterior component 1 can provide a wide range of design variations by combining the first light diffusion layer disposed in the first decorating layer K1 to the second light diffusion layer disposed in the second decorating layer K2.

8) When the sensor-sheet-containing exterior component 1 is viewed in plan, the decorating layer K1, K2 may be configured to form the first layered portion S1 and the second layered portion S2. The first layered portion S1 has the first light diffusion layer (the exterior light diffusion layer 35) and the second light diffusion layer (the intermediate light diffusion layer 25). The second layered portion S2 has one of the first light diffusion layer and the second light diffusion layer with the first light diffusion layer and the second light diffusion not being layered. The first layered portion S1 and the second layered portion S2 can change the visual effect of the sensor-sheet-containing exterior component 1. This can impart design flexibility to the sensor-sheet-containing exterior component 1.

9) The decorating layer K1, K2 has the transparent coloring layer (26a, 26b) that is light-transmissive and colored, and the transparent coloring layer (26a, 26b) includes the first transparent coloring layer (red coloring layer 26a) and the second transparent coloring layer (blue coloring layer 26b). Accordingly, a wide range of design variations can be obtained by combining the first transparent coloring layer, the second transparent coloring layer, and the light diffusion layers (25, 35) with one another. In other word, when the sensor-sheet-containing exterior component 1 is viewed in plan, the decorating layer K1, K2 may be configured to form the third layered portion S3, in which the second transparent coloring layer (blue coloring layer 26b) and the light diffusion layer (the intermediate light diffusion layer 25) are layered, and the fourth layered portion S4, in which the first transparent coloring layer (red coloring layer 26a) and the light diffusion layer (the exterior light diffusion layer 35) are not layered. The third layered portion S3 and the fourth layered portion S4 can change the visual effect of the sensor-sheet-containing exterior component 1. In addition, this can impart design flexibility to the sensor-sheet-containing exterior component 1.

10) The second decorating layer K2 is disposed in the intermediate sheet 20, 20a between the exterior member 30

and the sensor sheet 10, 10a. The intermediate sheet 20, 20a is a member separate from the exterior member 30 and the sensor sheet 10, 10a. The intermediate sheet 20, 20a can be decorated in various different ways separately from the exterior member 30 or the sensor sheet 10, 10a. This can impart design flexibility and variation to the sensor-sheet-containing exterior component 1.

11) The first decorating layer K1 includes the light blocking portion (exterior light blocking layer 37). The sensor-sheet-containing exterior component 1 has the adhesion layer 38 at positions in a region that overlaps the light blocking portion (the exterior light blocking layer 37). The adhesion layer 38 adheres the exterior member 30 to the intermediate sheet 20, 20a. The presence of the light blocking portion prevents light from illuminating interfaces of adhesion between the adhesion layer 38 and the exterior member 30 and also between the adhesion layer 38 and the intermediate sheet 20, 20a. Accordingly, even if bubbles enter the interfaces of adhesion, the sensor-sheet-containing exterior component 1 can avoid uneven illumination. Moreover, the sensor-sheet-containing exterior component 1 can also avoid uneven illumination occurring at edges of the adhesion layer 38.

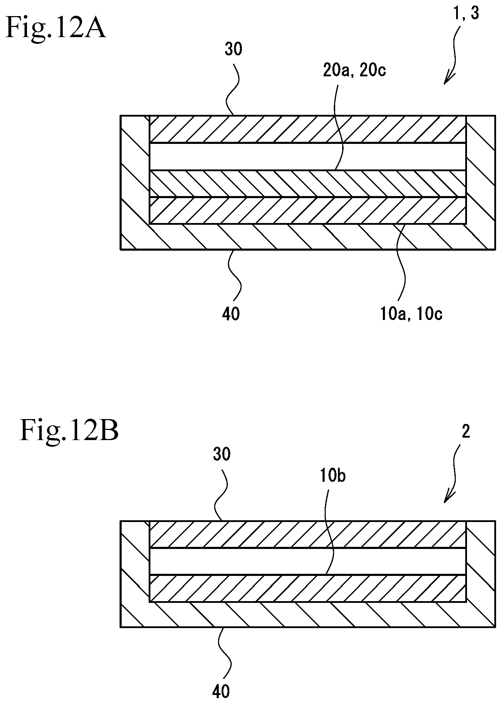

12) The sensor-sheet-containing exterior component 1 may include an inner member 40 at the side of the sensor sheet 10, 10a that is opposite to the side at which the exterior member 30 is disposed (Fig. 12). Accordingly, the sensor sheet 10 is positioned between, and thereby protected by, the exterior member 30 and the inner member 40. The sensor sheet 10 may be first adhered to the inner member 40 and subsequently incorporated into the exterior member 30, which leads to simplification of the manufacturing process.

13) The sensor-sheet-containing exterior component 1 may have the sensor sheet 10, 10a adhered to the inner member 40 but not adhered to the exterior member 30. The exterior member 30 is thereby formed so as to be attachable to or detachable from the sensor sheet 10 and the inner member 40, which leads to easy replacement of components for repairs.

14) The sensor-sheet-containing exterior component 1 may include an internal light source at the side of the sensor sheet 10, 10a that is opposite to the side at which the exterior member 30 is disposed.

The sensor-sheet-containing exterior component 1 can use the light from the internal light source, which further widens the range of design variations.

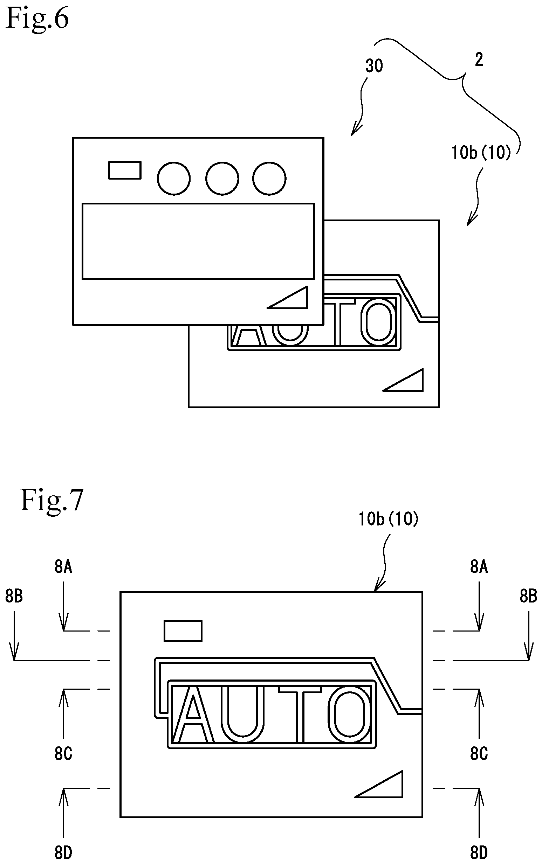

Second Embodiment (Figs. 6 to 8)

A plan view of a sensor-sheet-containing exterior component 2 according to a second embodiment is similar to that illustrated in Fig. 1. The sensor-sheet-containing exterior component 2 includes the exterior member 30 and the sensor sheet 10 as is the case for the sensor-sheet-containing exterior component 1 according to the first embodiment. The difference in configuration and in advantageous effect from the first embodiment is that the sensor-sheet-containing exterior component 2 has a sensor-side decorating layer K2b on the surface of the sensor sheet 10 as illustrated in Fig. 6. The sensor-side decorating layer K2b serves as the second decorating layer K2. Consequently, the sensor-sheet-containing exterior component 2 of the present embodiment does not include the intermediate sheet 20 having the intermediate decorating layer K2a.

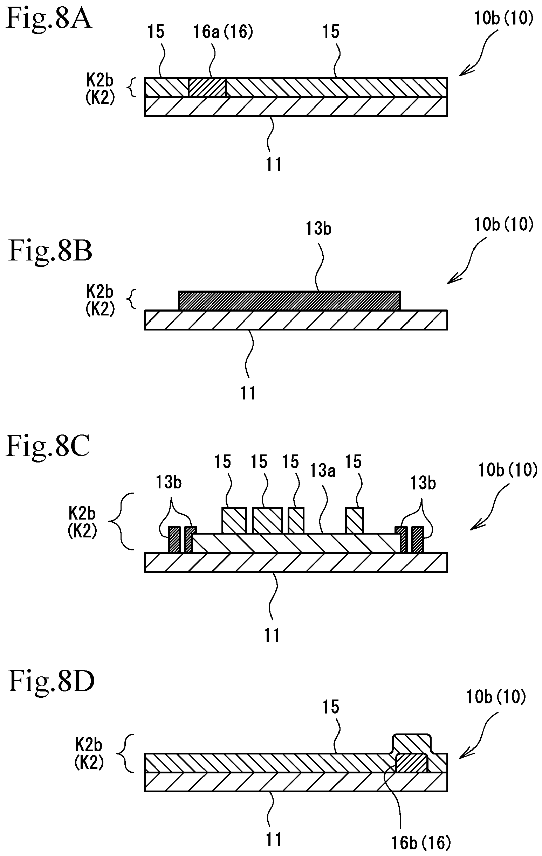

Fig. 7 is a plan view illustrating a sensor sheet 10 (a sensor sheet 10b according to the second embodiment) to be used for the sensor-sheet-containing exterior component 2. The sensor sheet 10b includes the sensor substrate 11 and the sensor 13, which are the same as those of the sensor sheet 10a described in the first embodiment. As illustrated in Fig. 7 and in Figs. 8, which are cross sections of the sensor sheet 10b, the sensor sheet 10b has a sensor-side light diffusion layer (second light diffusion layer) 15 and a sensor-side coloring layer 16 for displaying characters and symbols, which are formed at the surface of the sensor sheet 10b. The sensor-side light diffusion layer 15 is light-transmissive and also light-diffusive. The sensor-side light diffusion layer 15 can be formed as a semitransparent and colored coloring layer similar, for example, to colored smoky glass. In the present embodiment, the sensor-side coloring layer 16 is formed of a red coloring layer 16a and a blue coloring layer 16b. The sensor-sheet-containing exterior component 2 can be obtained by layering the exterior member 30 onto the sensor sheet 10b.

The following describes the configuration of the sensor-sheet-containing exterior component 2 in detail. The sensor-side coloring layer 16 is formed at the surface of the sensor substrate 11 of the sensor sheet 10b. The sensor-side coloring layer 16 includes a transparent blue coloring layer (second transparent coloring layer) 16b for the triangular shape (shape displaying portion) at the lower right corner. The second transparent coloring layer 16 also includes a transparent red coloring layer (first transparent coloring layer) 16a for the rectangular shape (shape displaying portion) at the upper left corner. The sensor-side light diffusion layer 15 is formed at the letters "AUTO" (letter displaying portion) and on the surface of the triangularly shaped blue coloring layer 16b. The sensor-side light diffusion layer 15 is layered on the blue coloring layer 16b in the triangular shape at the lower right corner. Thus, the sensor-side decorating layer K2b is formed in the sensor sheet 10b by layering the sensor-side coloring layer 16a, 16b and the sensor-side light diffusion layer 15. Note that the sensor-side light diffusion layer 15 is made of a material similar to that of the intermediate light diffusion layer 25, and the sensor-side coloring layer 16a, 16b is made of a material similar to that of the intermediate coloring layer 26, 26b.

The exterior member 30 is the same as that of the sensor-sheet-containing exterior component 1 of the first embodiment. The sensor-sheet-containing exterior component 2 with the above layer configuration has the first display portion D1, the second display portion D2, the third display portion D3, the fourth display portion D4, the fifth display portion D5, and the peripheral portion D6. These display portions operate similarly to those of the sensor-sheet-containing exterior component 1. In addition, the second display portion D2 is also the second layered portion S2, the third display portion D3 is also the fourth layered portion S4, the fourth display portion D4 is also the third layered portion S3, and the fifth display portion D5 is also the first layered portion S1. Accordingly, the sensor-sheet-containing exterior component 2 provides the visual effect similar to that of the sensor-sheet-containing exterior component 1 of the first embodiment.

In the sensor-sheet-containing exterior component 2, the adhesion layer 38 can be provided at the backside of the exterior substrate 31 at positions in a peripheral region that overlaps the exterior light blocking layer (light blocking portion) 37. The adhesion layer 38 adheres the exterior substrate 31 to the sensor sheet 10b.

Advantageous Effects

The sensor-sheet-containing exterior component 2 has the first decorating layer K1 formed in the exterior member 30 and the second decorating layer K2 (K2b) formed in the sensor sheet 10b that is the separate member from the exterior member 30. This can add an impression of depth to the decoration in the thickness direction of the sensor-sheet-containing exterior component 2, which widens the range of design variations.

The sensor-sheet-containing exterior component 2 does not include the intermediate sheet 20 used in the sensor-sheet-containing exterior component 1 of the first embodiment, which reduces the number of components and thereby leads to simplification of the manufacturing process. Moreover, this can reduce the distance between the surface of the sensor-sheet-containing exterior component 2 and the sensor electrode 13a, which can prevent the sensor sensitivity from decreasing.

In addition to those described above, the sensor-sheet-containing exterior component 2 can also provide the advantageous effects described in 1) to 3), 5), 7) to 9), and 11) to 14) in relation to the sensor-sheet-containing exterior component 1 of the first embodiment.

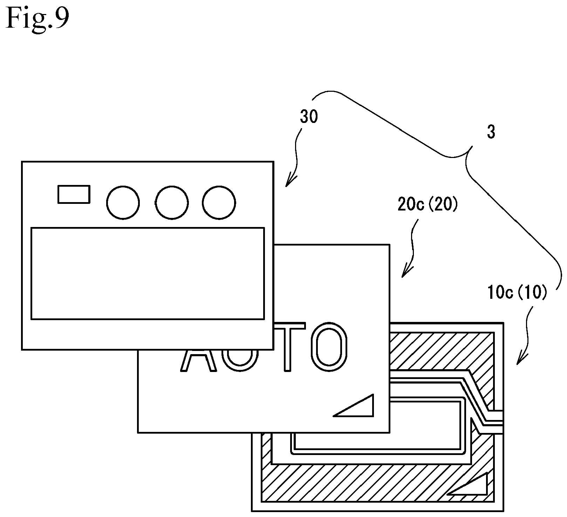

Third Embodiment (Figs. 9 to 11)

A plan view of a sensor-sheet-containing exterior component 3 according to a third embodiment is similar to that illustrated in Fig. 1. As illustrated in Fig. 9, the sensor-sheet-containing exterior component 3 includes the exterior member 30, the sensor sheet 10, and the intermediate sheet 20 as is the case for the sensor-sheet-containing exterior component 1 of the first embodiment. The difference in configuration and in advantageous effect from the first embodiment is that a decorating layer is formed also in the sensor sheet 10. In other words, the second decorating layer K2 is constituted by the intermediate decorating layer K2a formed in the intermediate sheet 20 and the sensor-side decorating layer K2b formed in the sensor sheet 10.

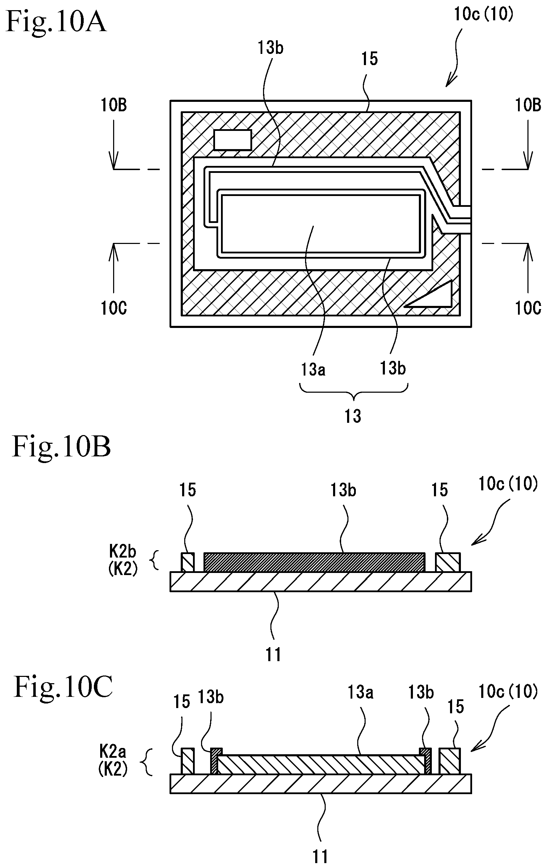

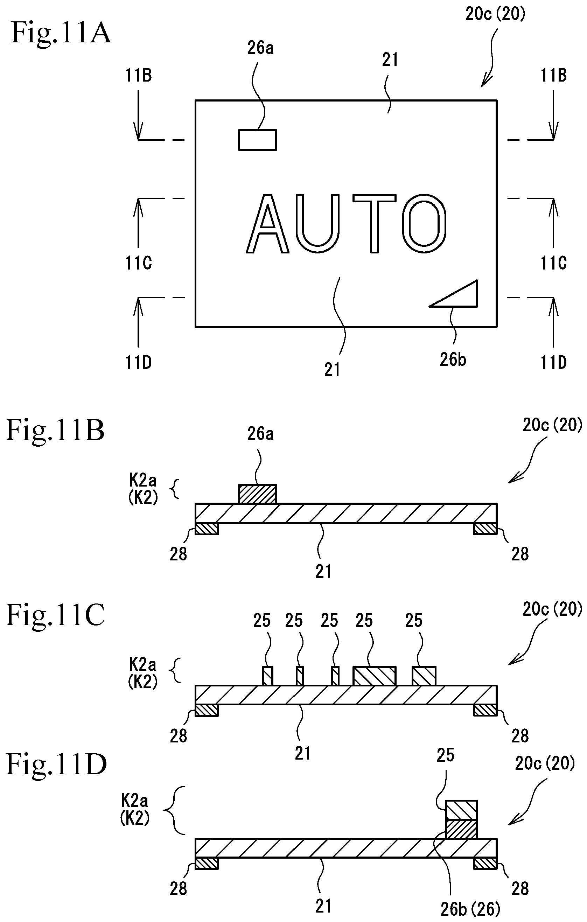

Fig. 10A is a plan view illustrating a sensor sheet 10 (a sensor sheet 10c according to the third embodiment) to be used for the sensor-sheet-containing exterior component 3. The sensor sheet 10c includes the sensor substrate 11 and the sensor 13, which are the same as those of the sensor sheet 10a described in the first embodiment. The sensor sheet 10c also includes the light-transmissive and also light-diffusive sensor-side light diffusion layer (second light diffusion layer) 15 at the surface thereof. Fig. 11A is a plan view of an intermediate sheet 20 (an intermediate sheet 20c according to the third embodiment). The intermediate sheet 20c has the intermediate substrate 21 formed of a transparent resin film and the intermediate coloring layer 26 formed on the surface of the intermediate substrate 21 for displaying characters and symbols. In the present embodiment, the intermediate coloring layer 26 is formed of the red coloring layer 26a and the blue coloring layer 26b. The sensor-sheet-containing exterior component 3 can be obtained by layering the sensor sheet 10c, the intermediate sheet 20c, and the exterior member 30.

More specifically, as illustrated in the plan view of Fig. 1, the triangular shape (shape displaying portion) at the lower right corner is formed of the transparent blue coloring layer (second transparent coloring layer) 26b that serves as the intermediate coloring layer 26. The rectangular shape (shape displaying portion) at the upper left corner is formed of the transparent red coloring layer (first transparent coloring layer) 26a that serves as the intermediate coloring layer 26. The intermediate light diffusion layer 25 is disposed on the surface of the intermediate substrate 21 in a region excluding the letters "AUTO" (letter displaying portion) and the rectangularly-shaped red coloring layer 26a. Accordingly, the intermediate light diffusion layer 25 is layered on the surface of the blue coloring layer 26b in the triangular shape. Thus, the intermediate decorating layer K2a is formed by layering the intermediate coloring layer 26a, 26b and the intermediate light diffusion layer 25.

The exterior member 30 is the same as that of the sensor-sheet-containing exterior component 1 of the first embodiment. The sensor-sheet-containing exterior component 3 with the above layer configuration has the first display portion D1, the second display portion D2, the third display portion D3, the fourth display portion D4, the fifth display portion D5, and the peripheral portion D6, and these display portions operate similarly to those of the sensor-sheet-containing exterior component 1. In addition, the second display portion D2 is also the second layered portion S2, the third display portion D3 is also the fourth layered portion S4, the fourth display portion D4 is also the third layered portion S3, and the fifth display portion D5 is also the first layered portion S1. Accordingly, the sensor-sheet-containing exterior component 3 provides the visual effect similar to that of the sensor-sheet-containing exterior component 1 of the first embodiment.

In the sensor-sheet-containing exterior component 3, the adhesion layer 38 can be provided at the backside of the exterior substrate 31 at positions in a peripheral region that overlaps the exterior light blocking layer (light blocking portion) 37. The adhesion layer 38 adheres the exterior substrate 31 to the intermediate sheet 20c. The adhesion layer 28 can be provided at the backside of the intermediate substrate 21 at positions corresponding to the adhesion layer 38. The adhesion layer 28 adheres the intermediate substrate 21 to the sensor sheet 10c.

Advantageous Effects

The sensor-sheet-containing exterior component 3 has the first decorating layer K1 formed in the exterior member 30 and the second decorating layer K2 formed in the intermediate sheet 20c and the sensor sheet 10c that are members separate from the exterior member 30. This can add an impression of depth to the decoration in the thickness direction of the sensor-sheet-containing exterior component 3, which widens the range of design variations.

The second decorating layer K2 is formed partly in the intermediate sheet 20c and partly in the sensor sheet 10c. This beneficially leads to an improvement in inventory adjustment of components having different design variations and also leads to an increase in the degree of freedom in the manufacturing process. This leads to a further increase in product variation, for example, by diversifying the disposal position of the coloring layer among the members in order to provide different impressions of depth.

In addition to those described above, the sensor-sheet-containing exterior component 3 can also provide the advantageous effects described in 1) to 14) in relation to the sensor-sheet-containing exterior component 1 of the first embodiment.

More Configurations and Advantageous Effects Common to First to Third Embodiment.

In all of the above-described embodiments, the first decorating layer K1 or the second decorating layer K2, including any constituent decorating layers, may overlap multiple sensor electrodes 13a as viewed in plan. In this case, if the area of the portion of the each sensor electrode 13a that overlaps the decorating layer K1, K2 is equal to or larger than a half of the area of the sensor electrode 13a, the resistance of the overlapping decorating layer K1, K2 obtained from the test described below is preferably approximately 100 K$\Omega$ or more, more preferably 1 M$\Omega$ or more, and even more preferably 100 M$\Omega$ or more, so as not to affect the performance of the sensor 13. The resistance of the decorating layer K1, K2 formed in the sensor-sheet-containing exterior component is to be measured by setting the distance between contact points (distance between probes) to be 7 mm. If the decorating layer K1, K2 is exposed, the resistance can be measured by directly touching the probes to the surface. If the decorating layer includes multiple layers or is layered with a protection layer or the like, the decorating layer can be tested by using needle-type probes and penetrating the probes to the target decorating layer. In place of the above-described way of measurement, the target decorating layer K1, K2 may be formed on a 100 $\mu$m thick transparent PET film to an approximate thickness of 5 to 10 $\mu$m, and the resistance of the target decorating layer may be measured at a contact-point distance (probe distance) of 7 mm. The reason for setting the condition that the area of the portion of the sensor electrode 13a that overlaps the decorating layer K1, K2 is equal to or larger than a half of the area of the sensor electrode 13a is that the area of the overlapped portion of the sensor electrode 13a tends to become considerable compared with the area of the sensor electrode 13a that a user's finger touches. Note that inks to be used for the decoration may be made without concern about conductivity. For example, a general-purpose black ink colored by carbon black may be conductive with relatively low resistance.

In all of the above embodiment, a transparent conductive ink to be used to form the sensor electrode may be colored and thereby used to form the transparent coloring layer of the decorating layer. A shield layer made of a carbon paste or a silver paste can be formed around the sensor electrode and the conducting wire. Since the carbon paste or the silver paste is a light blocking ink, the shield layer can be used to form the light blocking portion of the decorating layer. For example, transparent holes may be provided in the shield layer so as to form characters or symbols.

In all of the above embodiments, an inner member 40, of which examples are illustrated in Figs. 12A and 12B, may be provided at the side of the sensor sheet 10 that is opposite to the side at which the exterior member 30 is disposed. The sensor sheet 10 may be fixed to the inner member 40, and the inner member 40 may be fixed to the exterior member 30. This enables the sensor sheet 10b or the intermediate sheet 20a, 20c to be layered on the exterior member 30 without fixing these sheets to the exterior member 30.

In all of the above embodiments, the decorating layer K1, K2 may include a black layer of which the lightness value L* is 10 or less in the L*a*b* color space of CIE 1976 as stipulated in JIS Z8781-4: 2013. Carbon black is often used as a coloring pigment for a black layer, but the carbon black may lower the resistance of the black layer. In this case, the resistance of the black layer can be maintained at 100 kΩ or more by adjusting the amount of the carbon black or by using titanium black or other pigments solely or together with the carbon black, which can provide the black appearance while reducing the likelihood of the sensor sheet 10 functioning wrongly when used as the touch sensor.

The embodiments described above are examples according to the present invention. The embodiments may be modified or known techniques may be added thereto or combined therewith without departing from the scope of the invention. Such modifications, additions, and combinations are to be within the scope of the present invention.

For example, the intermediate light diffusion layer 25 may be formed as a printed layer using a smoke ink or alternatively formed using a smoke film or a light-diffusive film or the like.

EXAM PLES

Preparation of Samples 1-1 to 7-1

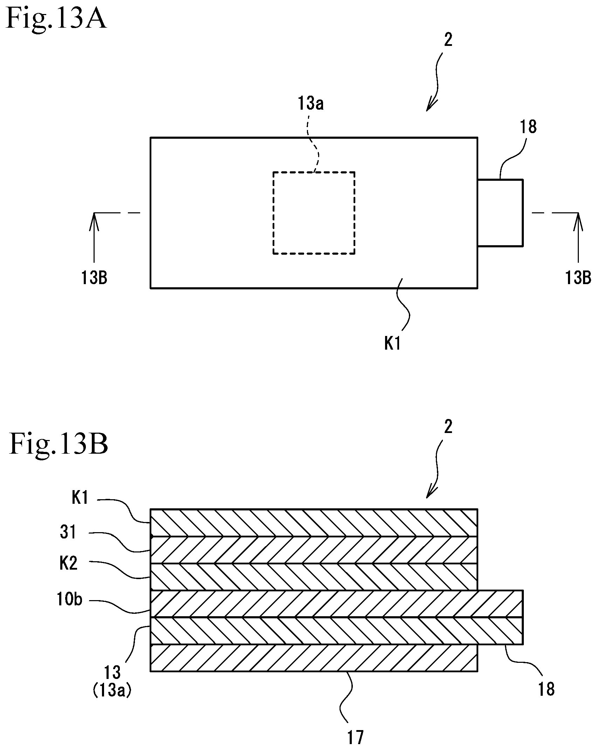

Multiple test pieces were prepared to study how the decorating layer of the sensor-sheet-containing exterior component of the present invention affects sensor sensitivity. These test pieces simulated the sensor-sheet-containing exterior component but had a simplified layer structure as illustrated in Fig. 13B. More specifically, an exterior substrate (31) of an exterior member (30) were prepared using a 1.0 mm thick polycarbonate sheet, and a sensor substrate (11) of a sensor sheet (10b) were prepared using a 100 μm thick PET film. As illustrated in Figs. 13, a first decorating layer (exterior decorating layer) (K1) was formed on the surface of the exterior substrate (31) using an insulating special black ink. A second decorating layer (sensor-side decorating layer) (K2) was formed on the surface of an intermediate substrate (21), which will be described later. A sensor (13) was formed by printing a sensor electrode (13a) on the backside of the intermediate substrate (21) using a transparent conductive ink and by printing a conducting wire (13b) using a silver ink. A resist layer (17) was subsequently formed on the backside of the sensor (13) using a polyurethane-based resin ink. Test pieces having the layer configuration illustrated in Figs. 13 were prepared by bringing, without fixing, the exterior member (30) and the sensor sheet (10b) into close contact with each other. Note that the sensor electrode (13a), which is indicated by the dotted line in Fig. 13A, is formed in the layer having the sensor (13). The sensor electrode (13a) is coupled to the conducting wire (not illustrated) that extends to a terminal (18) provided for connection with a measuring instrument (PSoC), which will be described later.

A second decorating layer (K2) was formed using an ink made by mixing a conductive black ink with the special black ink used for the first decorating layer (K1). The mix proportion of the conductive black ink and the special black ink was changed to obtain seven different test pieces, Sample 1-1 to Sample 7-1, of which respective second decorating layers (K2) have different resistances. Sample 1-1 is a test piece in which the second decorating layer is formed of 100 mass% of the special black ink (0 mass% of the conductive black ink). The ratio by mass of the special black ink to the conductive black ink of the second decorating layer for Sample 2-1 is 9 : 1. In the same manner, the ratio for Sample 3-1 is 8 : 2; the ratio for Sample 4-1 is 7 : 3; the ratio for Sample 5-1 is 5 : 5; and the ratio for Sample 6-1 is 3 : 7. The second decorating layer for Sample 7-1 is formed of 100 mass% of the conductive black ink (0 mass% of the special black ink). Note that the special black ink contains titanium black as an insulating black pigment and the conductive black ink contains carbon black, which is a general black pigment.

Measurement of Resistance of Second Decorating Layer (K2)

The resistance of the second decorating layer (K2) was measured in the following manner. In the measurement of resistance, the probes of a tester (Advantest R8340 Ultra High Resistance Meter, Measurement Voltage: 30V) were pressed against the surface of the second decorating layer (K2) at a position corresponding to the 20 mm by 20 mm sensor electrode (13a) with the probe distance set to be 7 mm, before the sensor sheet (10b) was brought into close contact with the polycarbonate sheet of the exterior member. Note that in each test piece, the probes were directly pressed against the surface of the second decorating layer (K2) that was formed as a single exposed layer. If the second decorating layer (K2) includes multiple layers or is layered with other protection layers or the like, each decorating layer can be discretely measured by using needle-type probes and penetrating the probes to the target decorating layer.

Measurement of Sensor Sensitivity

The sensor sensitivity (otherwise referred to as "sensor output") was measured by connecting the terminal of each test piece to PSoC IC (Cypress Microcomputer CY 8C24894, PRS 12 Module with Prescaler) with the sensor sheet (10b) being in close contact with the exterior member (31) that included the first decorating layer (K1). Parameters of PSoC IC were set as follows: 12 bit (4095) for Resolution, 2 for Ref Value, "Normal" for Scanning Speed, 127 for Prescaler Period, "Short" for PRS Polynominal, and 100 kΩ for Rb Resistance.

In the measurement, a cylindrically shaped measuring probe (in other words, a pressing piece that simulates a user's finger) having a diameter of 6 mm and being made of conductive rubber was pressed against a central portion of the sensor electrode (13a) to obtain DIF. Among outputs obtained in the measurement, DIF is a difference in sensor output (in other words, value corresponding to capacitance) between before and after the pressing piece was pressed against the sensor electrode (13a). In addition, RAW is a sensor output measured when the pressing piece is not pressed against the sensor electrode (13a). RAW is the value affected, for example, by parasitic capacitance.

Table 1 collates measured results of DIF, RAW, and resistance of the second decorating layer (K2) for each of Samples 1-1 to 7-1.

[Table 1]

|  | Sample 1-1 | Sample 2-1 | Sample 3-1 | Sample 4-1 | Sample 5-1 | Sample 6-1 | Sample 7-1 |
|---|---|---|---|---|---|---|---|
| Resistance (Ω) | 7.8G | 5.7G | 0.41G | 0.50M | 6.3k | 1.1k | 0.21k |
| RAW | 1873.3 | 1887.4 | 1965.2 | 2811.5 | 3057.5 | 3074.7 | 3035.3 |
| DIF | 75.5 | 67.1 | 52.6 | 55.7 | 49.1 | 43.4 | 41.3 |

Preparation of Samples 1-2 to 7-2

Seven test pieces or Samples 1-2 to 7-2 were prepared by replacing the 1.0 mm thick polycarbonate sheet of the exterior substrate (31) of Samples 1-1 to 7-1 with a 0.5 mm thick polycarbonate sheet with other conditions remaining the same. Samples 1-2 to 7-2 were measured for DIF and RAW of the sensor sensitivity (sensor output) with the same measurement conditions as those for Samples 1-1 to 7-1. Results are collated in Table 2. Note that results of the resistance of the second decorating layer (K2) of Samples 1-2 to 7-2 are the same as those of Samples 1-1 to 7-1 because the same sensor sheets (10b) are used. Accordingly, Table 2 lists the same values as for Samples 1-1 to 7-1.

[Table 2]

|  | Sample 1-2 | Sample 2-2 | Sample 3-2 | Sample 4-2 | Sample 5-2 | Sample 6-2 | Sample 7-2 |
|---|---|---|---|---|---|---|---|
| Resistance (Ω) | 7.8G | 5.7G | 0.41G | 0.50M | 6.3k | 1.1k | 0.21k |
| RAW | 1884.5 | 1895.6 | 1956.3 | 2797.9 | 3088.1 | 3101.2 | 3054.3 |
| DIF | 89.9 | 87.6 | 82.1 | 64.6 | 63.1 | 55.5 | 60.4 |

Preparation of Samples 8 to 14

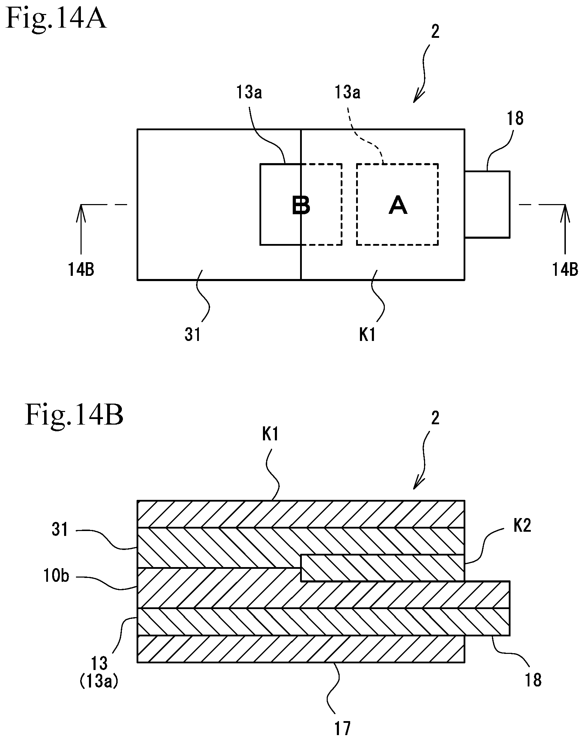

Seven test pieces or Samples 8 to 14 were prepared by replacing the 1.0 mm thick polycarbonate sheet of the exterior substrate (31) of Samples 1-1 to 7-1 with the 0.5 mm thick polycarbonate sheet. In addition, in Samples 8 to 14, the sensor electrode (13a) was changed to a sensor electrode A (13a) and a sensor electrode B (13a) as illustrated in Fig. 14A. Moreover, the second decorating layer (sensor-side decorating layer) (K2) disposed in the sensor sheet (10b) covered the entire portion of the sensor electrode A (13a) and a half portion of the sensor electrode B (13b) (see Fig. 14B). Other conditions were the same as those for Samples 1-1A to 7-1A.

The method of measuring the resistance of the second decorating layer (K2) was basically the same as that for Samples 1-1 to 7-1. In the measurement of resistance, the probes of the tester were pressed against the surface of the second decorating layer (K2) at a position corresponding to the 20 mm by 20 mm sensor electrode A (13a) with the probe distance set to be 7 mm, before the sensor sheet (10b) was brought into close contact with the polycarbonate sheet of the exterior member.

DIFs of the sensor sensitivity (sensor output) were measured, in which DIF 3 was the output of the sensor electrode A when the pressing piece was pressed against the sensor electrode A, DIF 4 was the output of the sensor electrode B when the pressing piece was pressed against the sensor electrode A, DIF 5 was the output of the sensor electrode A when the pressing piece was pressed against the sensor electrode B, and DIF 6 was the output of the sensor electrode B when the pressing piece was pressed against the sensor electrode B. Various DIFs are measured to determine the amount of the influence that the sensor electrode receives. For example, DIF 4 is the output of the sensor electrode B when the pressing piece is pressed against the sensor electrode A. In other words, DIF 4 indicates the amount of the influence that the untouched sensor electrode receives when the adjacent sensor electrode is touched by the pressing piece, in other words, touched by a user's finger. It is ideal, as a matter of course, that the untouched sensor electrode be not responded (DIF = 0).

A signal-to-noise ratio (SN ratio) A and a signal-to-noise ratio (SN ratio) B are calculated from the following equations 1 and 2.

$$\text{SN ratio A} = \text{DIF 3} / \text{DIF 5} \qquad \text{(Equation 1)}$$

$$\text{SN ratio B} = \text{DIF 6} / \text{DIF 4} \qquad \text{(Equation 2)}$$

As expressed in the above equations, the SN ratio A is the ratio of the output of the sensor electrode A with the sensor electrode A being touched to the output of the sensor electrode A with the sensor electrode B being touched. For example, if the output of the sensor electrode A is large when the sensor electrode B is touched, it becomes difficult to determine whether the sensor electrode A is touched or the sensor electrode B is touched even if the sensor electrode A outputs a predetermined value. Accordingly, a SN ratio A being closer to one may lead to malfunction, in other words, inability of determining the sensor electrode that has been touched. The greater the SN ratio, the better it is. The SN ratio is preferably 2 or more, more preferably 3 or more, and even more preferably 5 or more. Results including the above are collated in Table 3 below.

[Table 3]

|  |  |  | Sample 8 | Sample 9 | Sample 10 | Sample 11 | Sample 12 | Sample 13 | Sample 14 |
|---|---|---|---|---|---|---|---|---|---|
| Resistance ($\Omega$) |  |  | 7.7G | 5.8G | 0.43G | 0.51M | 6.5k | 1.2k | 0.22k |
| DIF | DIF3 | (A is pressed, A is measured) | 89.3 | 88.2 | 82.1 | 56.9 | 55.6 | 52.9 | 54.4 |
|  | DIF4 | (A is pressed, B is measured) | 15.5 | 16.1 | 13.5 | 9.5 | 21.5 | 22.7 | 20.5 |
|  | DIF5 | (B is pressed, A is measured) | 17.2 | 15.1 | 12.7 | 15.9 | 48.5 | 44.9 | 46.8 |
|  | DIF6 | (B is pressed, B is measured) | 86.5 | 87.7 | 85.0 | 38.2 | 32.1 | 27.8 | 31.4 |
| SN ratio | SN ratio A |  | 5.2 | 5.8 | 6.5 | 3.6 | 1.1 | 1.2 | 1.2 |
|  | SN ratio B |  | 5.6 | 5.4 | 6.3 | 4.0 | 1.5 | 1.2 | 1.5 |

According to Table 3, the resistance of the second decorating layer (K2) is preferably about 100 k$\Omega$ or more, more preferably 1 M$\Omega$ or more, and even more preferably 100 M$\Omega$ or more.

Reference Signs List

| | |
|---|---|
| 1 | sensor-sheet-containing exterior component (first embodiment) |
| 2 | sensor-sheet-containing exterior component (second embodiment) |
| 3 | sensor-sheet-containing exterior component (third embodiment) |
| 10 | sensor sheet |
| 10a | sensor sheet (first embodiment) |
| 10b | sensor sheet (second embodiment) |
| 10c | sensor sheet (third embodiment) |
| 11 | sensor substrate |
| 13 | sensor |

| 13a | sensor electrode |
| 13b | conducting wire |
| 15 | sensor-side light diffusion layer |
| 16, 16a, 16b | sensor-side coloring layer |
| 16a | red coloring layer |
| 16b | blue coloring layer |
| 17 | resist layer |
| 18 | terminal |
| 20 | intermediate sheet |
| 20a | intermediate sheet (first embodiment) |
| 20c | intermediate sheet (third embodiment) |
| 21 | intermediate substrate |
| 25 | intermediate light diffusion layer |
| 26, 26a, 26b | intermediate coloring layer |
| 26a | red coloring layer |
| 26b | blue coloring layer |
| 28 | adhesion layer |
| 30 | exterior member |
| 31 | exterior substrate |
| 35 | exterior light diffusion layer |
| 36 | exterior coloring layer |
| 37 | exterior light blocking layer |
| 38 | adhesion layer |
| 40 | inner member |
| K1 | first decorating layer (exterior decorating layer) |
| K2 | second decorating layer (intermediate decorating layer, sensor-side decorating layer) |
| K2a | intermediate decorating layer |
| K2b | sensor-side decorating layer |
| D1 | first display portion (circle) |
| D2 | second display portion (AUTO) |
| D3 | third display portion (rectangle) |
| D4 | fourth display portion (triangle) |
| D5 | fifth display portion (background of AUTO) |
| D6 | peripheral portion |
| S1 | first layered portion |
| S2 | second layered portion |
| S3 | third layered portion |
| S4 | fourth layered portion |

**Claims**

1. A sensor-sheet-containing exterior component in which an exterior member and a sensor sheet are layered, the sensor-sheet-containing exterior component comprising:

   a decorating layer that decorates a display portion that appears on a surface of the exterior member, wherein the decorating layer includes a first decorating layer disposed in the exterior member and a second decorating layer positioned closer than the first decorating layer to the sensor sheet and disposed in a separate member separate from the exterior member.

2. The sensor-sheet-containing exterior component according to Claim 1, wherein

   the decorating layer has a light diffusion layer that is light-transmissive and also light-diffusive, the light diffusion layer including a first light diffusion layer disposed in the first decorating layer and a second light diffusion layer disposed in the second decorating layer, and
   when the sensor-sheet-containing exterior component is viewed in plan, the decorating layer has

      a first layered portion in which the first light diffusion layer and the second light diffusion layer are layered, and

a second layered portion that has one of the first light diffusion layer and the second light diffusion layer with the first light diffusion layer and the second light diffusion layer not being layered.

3. The sensor-sheet-containing exterior component according to Claim 1 or 2, wherein

the decorating layer has a transparent coloring layer that is light-transmissive and colored, the transparent coloring layer including a first transparent coloring layer and a second transparent coloring layer, and when the sensor-sheet-containing exterior component is viewed in plan, the decorating layer has

a third layered portion in which the first transparent coloring layer and the light diffusion layer are layered, and a fourth layered portion in which the second transparent coloring layer and the light diffusion layer are not layered.

4. The sensor-sheet-containing exterior component according to any one of Claims 1 to 3, wherein the decorating layer extends over multiple sensor electrodes as viewed in plan, a portion of the decorating layer overlapping one of the multiple sensor electrodes is equal to or larger than a half of an area of the one of the multiple sensor electrodes, and the decorating layer has a resistance of 100 k$\Omega$ or more when measured at a probe distance of 7 mm.

5. The sensor-sheet-containing exterior component according to any one of Claims 1 to 4, wherein the second decorating layer is disposed in an intermediate sheet that is disposed as a separate member between the exterior member and the sensor sheet.

6. The sensor-sheet-containing exterior component according to any one of Claims 1 to 4, wherein the second decorating layer is disposed in the sensor sheet that serves as a separate member separate from the exterior member.

7. The sensor-sheet-containing exterior component according to Claim 6, wherein

the first decorating layer has a light blocking portion, and the exterior member and the sensor sheet are fixed to each other by an adhesion layer disposed at a position overlapping the light blocking portion.

8. The sensor-sheet-containing exterior component according to any one of Claims 1 to 4, wherein the second decorating layer is separated into and disposed in the sensor sheet and an intermediate sheet that is disposed as a separate member between the exterior member and the sensor sheet.

9. The sensor-sheet-containing exterior component according to Claim 5 or 7, wherein

the first decorating layer has a light blocking portion, and the exterior member and the intermediate sheet are fixed to each other by an adhesion layer disposed at a position overlapping the light blocking portion.

10. The sensor-sheet-containing exterior component according to any one of Claims 1 to 9, further comprising: an inner member disposed at a side of the sensor sheet that is opposite to a side at which the exterior member is disposed.

11. The sensor-sheet-containing exterior component according to Claim 10, wherein

the sensor sheet is fixed to the inner member, and the sensor sheet is layered on the exterior member without being fixed to the exterior member.

12. The sensor-sheet-containing exterior component according to any one of Claims 1 to 11, further comprising: an internal light source disposed at the side of the sensor sheet that is opposite to the side at which the exterior member is disposed.

Fig.1

D3
(S4)　D1　D1　D1

1

D2
(S2)

D4
(S3)

D5
(S1)　　D2
(S2)　　D6

Fig.2

30

1

20a (20)

10a (10)

Fig.3A

10a (10)

13b
11

3B
3B

3C
3C

13a 13b

13

Fig.3B

13b
10a (10)

11

Fig.3C

13b 13a 13b 10a (10)

11

Fig.4A

Fig.4B

Fig.4C

Fig.4D

Fig.5A

Fig.5B

Fig.5C

Fig.5D

Fig.6

Fig.7

Fig.8A

15 16a (16) 15  10b (10)

K2b
(K2)

11

Fig.8B

13b  10b (10)

K2b
(K2)

11

Fig.8C

13b 15 15 15 13a 15  13b  10b (10)

K2b
(K2)

11

Fig.8D

15  10b (10)

K2b
(K2)

11 16b (16)

Fig.9

Fig.10A

Fig.10B

Fig.10C

Fig.11A

Fig.11B

Fig.11C

Fig.11D

Fig.12A

30

20a, 20c

1, 3

40

10a, 10c

Fig.12B

30

10b

2

40

Fig.13A

Fig.13B

**Fig.14A**

**Fig.14B**

**EP 3 955 275 A1**

<table>
<tr><td colspan="3"><strong>INTERNATIONAL SEARCH REPORT</strong></td><td>International application No.<br><br>PCT/JP2020/018983</td></tr>
</table>

| A. CLASSIFICATION OF SUBJECT MATTER |
|---|
| H01H 36/00(2006.01)i; B32B 7/023(2019.01)i; G06F 3/02(2006.01)i<br>FI: G06F3/02 400; H01H36/00 L; H01H36/00 J; B32B7/023 |

According to International Patent Classification (IPC) or to both national classification and IPC

| B. FIELDS SEARCHED |
|---|
| Minimum documentation searched (classification system followed by classification symbols)<br>H01H36/00; B32B7/023; G06F3/02 |

| Documentation searched other than minimum documentation to the extent that such documents are included in the fields searched | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| X<br>A | JP 2016-530621 A (ELBEX VIDEO LTD.) 29.09.2016<br>(2016-09-29) paragraphs [0023]-[0082] | 1, 4-12<br>2-3 |
| A | JP 2009-212031 A (HAKODATE SEKONIC INC.)<br>17.09.2009 (2009-09-17) paragraphs [0035]-[0077] | 1-12 |

☐ Further documents are listed in the continuation of Box C.   ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>08 June 2020 (08.06.2020) | Date of mailing of the international search report<br>23 June 2020 (23.06.2020) |
|---|---|
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

27

**INTERNATIONAL SEARCH REPORT**
Information on patent family members

International application No.

PCT/JP2020/018983

| Patent Documents referred in the Report | Publication Date | Patent Family | Publication Date |
|---|---|---|---|
| JP 2016-530621 A | 29 Sep. 2016 | US 8742892 B1 column 4, line 14 to column 11, line 9 WO 2015/017142 A1 CA 2919861 A1 CN 105431802 A KR 10-2016-0038049 A | |
| JP 2009-212031 A | 17 Sep. 2009 | (Family: none) | |

Form PCT/ISA/210 (patent family annex) (January 2015)

**EP 3 955 275 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2011142332 A